# EUROPÄISCHE PATENTSCHRIFT

(11) **EP 3 189 589 B1**
(45) Veröffentlichungstag und Bekanntmachung des Hinweises auf die Patenterteilung: **11.11.2020**
(21) Anmeldenummer: 15756148.1
(22) Anmeldetag: 25.08.2015
(51) Int. Cl.: H03H 9/10, H01L 21/56, B81B 3/00, H01L 23/04, B81C 1/00

(54) **ABDECKUNG FÜR EIN BAUELEMENT UND VERFAHREN ZUR HERSTELLUNG EINER ABDECKUNG FÜR EIN BAUELEMENT**
COVER FOR A COMPONENT AND METHOD FOR MANUFACTURING IT
CAPOT POUR UNE COMPOSANTE ET PROCÉDÉ DE SA FABRICATION

(30) Priorität: 03.09.2014 DE 102014112672
(43) Veröffentlichungstag der Anmeldung: 12.07.2017
(73) Patentinhaber: SnapTrack, Inc., San Diego, CA 92121 (US)
(72) Erfinder: SCHÄUFELE, Ansgar, 81667 München (DE)
(74) Vertreter: Wegner, Hans
(86) Internationale Anmeldenummer: PCT/EP2015/069453
(87) Internationale Veröffentlichungsnummer: WO 2016/034456

(56) Entgegenhaltungen:
- EP-A2- 1 251 099
- EP-A2- 1 640 329
- WO-A2-2010/049837
- DE-A1- 2 418 794
- US-A1- 2004 061 207
- US-A1- 2009 179 287
- US-A1- 2009 194 309
- US-A1- 2011 062 826
- US-A1- 2014 231 934

## Beschreibung

Es wird eine Abdeckung für ein Bauelement angegeben. Beispielsweise weist das Bauelement eine Bauelementstruktur auf, die als MEMS- (mikro-elektromechanisches System), BAW- oder SAW-Struktur ausgebildet ist. Insbesondere wird durch die mit der Abdeckung versehenen Struktur ein Bauelement in Package-Form bereitgestellt. Vorzugsweise ist die Abdeckung in Dünnschicht-Technologie hergestellt. Weiterhin wird ein Verfahren zur Herstellung einer derartigen Abdeckung angegeben.

Eine Abdeckung eines elektrischen Bauelements dient beispielsweise zum Schutz einer Bauelementstruktur vor mechanischen und/oder chemischen Einflüssen. Zudem wird durch die Abdeckung ein definierter Hohlraums für die Bauelementstruktur gebildet. Aus der Druckschrift DE 10 2011 103 516 A1 geht ein Verfahren zur Herstellung einer Abdeckung hervor. Das Dokument US 20090194309A1 bezieht sich auf eine Mikrokomponente, die einen durch eine Abdeckung (12) begrenzten Hohlraum (13) aufweist, der einen von einem Substrat (11) getragenen aktiven Teil (10) ein vorstehendes Versteifungselement (12b), wobei das Versteifungselement zwischen zwei vertieften Bereichen (12c) der oberen Wand (12a) angeordnet ist und ein Ende (14) in einem Abstand von den vertieften Bereichen ohne mit dem Substrat (11) in Kontakt zu kommen.

Das Dokument EP 1251099A2 bezieht sich auf Strukturen, Verfahren und Mittel, um mechanische Spannungen in mikroelektromechanischen Systemen zu erzeugen, indem das Trägheitsmoment einiger der komponierenden Elemente erhöht wird. Ein thermischer Sensor wird mit verbesserter mechanischer Festigkeit, Wärmedämmung und Zeitkonstante bereitgestellt. Die vorgeschlagene Erfindung ist auch hinsichtlich der Verfahrenszeit und der Herstellungskosten, insbesondere der lithographischen Strukturierung, vorteilhaft.

Das Dokument US 20090179287A1 bezieht sich auf eine funktionelle Vorrichtung, die die folgende Komponenten umfasst: ein Substrat; eine funktionelle Struktur, die auf dem Substrat gebildet ist; einen Hohlraum, in dem die funktionelle Struktur angeordnet ist; und eine Abdeckung, die den Hohlraum bedeckt, wobei die Abdeckung eine holprige Struktur mit rippenförmigen Abschnitten oder rillenförmigen Abschnitten umfasst, die einen Abdeckungsbereich kreuzen, der zumindest den Hohlraum bedeckt.

Das Dokument US 20140231934A1 bezieht sich auf ein elektrisches Bauelement, das die folgende Komponenten umfasst: ein Substrat, ein auf dem Substrat gebildetes Funktionselement, eine erste Schicht, die dazu konfiguriert ist, einen Hohlraum zu bilden, der das Funktionselement auf dem Substrat enthält, wobei die erste Schicht Durchgangslöcher aufweist, wobei die erste Schicht einen ersten vertieften Abschnitt und einen ersten vorstehenden Abschnitt auf einer oberen Oberfläche davon aufweist und die erste Schicht in einer Richtung senkrecht zu einer Oberfläche des Substrats unterschiedliche Filmdicken aufweist und eine zweite Schicht, die auf der ersten Schicht ausgebildet ist und so konfiguriert ist, um die Durchgangslöcher zu verschließen.

Das Dokument US 20110062826A1 bezieht sich auf oberflächenmontierte piezoelektrische Vorrichtungen, die eine Baugruppe mit einer Basis und einem Deckel aus einem piezoelektrischen Material oder aus Glas umfassen. Die Baugruppe definiert einen inneren Hohlraum, der ein Vibrationsstück vom Stimmgabel-Typ mit einem Paar Schwingarmen enthält. Das Volumen des Hohlraums ist mindestens das Zwölffache des Volumens des Schwingarmpaars. Piezoelektrische Vorrichtungen mit diesen Eigenschaften weisen eine verminderte CI-Verschlechterung auf.

Das Dokument WO 2010049837A2 bezieht sich auf eine integrierte Komponente mit einem Substrat, eines auf dem Substrat ausgebildeten Abdeckung zum Umschließen eines Hohlraums mit einer Oberfläche des Substrats und einer Verstärkungsstruktur um die Abdeckung zu verstärken, die sich von einem zentralen Abschnitt der Abdeckung entlang der Abdeckung zu erstreckt.

Das Dokument EP 1640329A2 bezieht sich auf eine elektronische Vorrichtung, die interferometrische Modulation verwendet und auf eine Verpackung der Vorrichtung. Die verpackte Vorrichtung umfasst ein Substrat, eine interferometrische Modulations-Anzeigeanordnung, die auf dem Substrat ausgebildet ist, und eine Rückplatte. Die Rückplatte ist über der Anzeigeanordnung angeordnet, wobei eine Lücke zwischen der Rückplatte und der Anzeigeanordnung vorliegt. Die Vorrichtung umfasst ferner Verstärkungsstrukturen, die in die Rückplatte integriert sind. Die Verstärkungsstrukturen erhöhen die Steifigkeit der Rückplatte. Die Rückplatte kann eine Dicke aufweisen, die entlang einer Kante davon variiert. Das Dokument US 20040061207 A1 bezieht sich auf eine Mikrovorrichtung, die eine Mikrostruktur der Vorrichtung, ein Substrat und eine Siliziumabdeckung umfasst. Die Mikrostruktur der Vorrichtung ist an dem Substrat befestigt. Die Silikonabdeckung weist einen Basisabschnitt und eine Seitenwand auf, die eine Aussparung in der Abdeckung definiert. Die Siliziumabdeckung ist so an dem Substrat befestigt, dass die Aussparung die Mikrostruktur der Vorrichtung beinhaltet und eine hermetisch versiegelte Kavität benachbart zu der Mikrostruktur der Vorrichtung ausbildet. Die Siliziumabdeckung weist ferner eine entlang ihrer Aussparung eingebettete einkristalline Silizium-Getterschicht zum Aufrechterhalten eines Vakuums innerhalb des Hohlraums auf.

Es ist eine Aufgabe der vorliegenden Erfindung, eine verbesserte Abdeckung und ein Verfahren zur Herstellung einer verbesserten Abdeckung für eine Bauelementstruktur anzugeben.

Gemäß einem ersten Aspekt der vorliegenden Erfindung wird eine Abdeckung für ein Bauelement angegeben. Die Abdeckung ist vorzugsweise in Dünnschicht-Technologie hergestellt. Beispielsweise weist das Bauelement eine abzudeckende Bauelementstruktur auf. Beispielsweise handelt es sich dabei um eine Filter- und/oder eine Duplexerstruktur. Insbesondere kann es sich um ein oder mehrere Resonatoren, beispielsweise kaskadierte Resonatoren handeln. Die vorliegende Erfindung ist durch die Ansprüche definiert. Die Beschreibung kann beispielhafte Abdeckungen umfassen, die nicht unter den Gegenstand der Ansprüche fallen.

Die angegebene Abdeckung weist eine Unterseite auf, die der Bauelementstruktur zugewandt ist, und eine Oberseite, die der Bauelementstruktur abgewandt ist. An die Oberseite schließt sich der Außenraum des Bauelements an. Beispielsweise sind die Bauelementstruktur und die Abdeckung auf einem Trägersubstrat angeordnet. Somit ist die Unterseite die Seite der Abdeckung, die dem Trägersubstrat zugewandt ist und die Oberseite die Seite, die dem Trägersubstrat abgewandt ist. Die Abdeckung begrenzt beispielsweise einen Hohlraum. Die Unterseite schließt sich vorzugsweise direkt an den Hohlraum an.

Dabei umfasst die beanspruchte Abdeckung wenigstens eine Schicht, die eine Strukturierung mit mehreren Erhebungen und Vertiefungen aufweist, wobei die Strukturierung der Erhöhung der mechanischen Stabilität der Abdeckung dient;
wobei die Abdeckung mehrere übereinander angeordnete Schichten aufweist, wobei die Abdeckung eine unterste Schicht, wenigstens eine mittlere Schicht und eine oberste Schicht aufweist, wobei eine Unterseite der untersten Schicht die Unterseite der Abdeckung bildet und eine Oberseite der obersten Schicht die Oberseite der Abdeckung bildet;
wobei die Unterseite und die Oberseite der Abdeckung frei von Erhebungen oder Vertiefungen sind, wobei die Strukturierung in der mittleren Schicht und in der obersten Schicht ausgebildet ist und wobei die mittlere Schicht auf ihrer Oberseite ihre Strukturierung mit Erhebungen und Vertiefungen aufweist und wobei die oberste Schicht auf ihrer Unterseite ihre Strukturierung mit Erhebungen und Vertiefungen aufweist, wobei die oberste Schicht auf ihrer Unterseite komplementär zur Oberseite der mittleren Schicht ausgebildet ist, indem die Vertiefungen in der mittleren Schicht vollständig mit dem Material der obersten Schicht aufgefüllt sind.

Durch eine derartige Strukturierung wird vorzugsweise die mechanische Stabilität der Abdeckung erhöht. Dies ermöglicht beispielsweise eine Vergrößerung der Grundfläche der Abdeckung. Weiterhin erlaubt eine derart stabile Abdeckung auch das Aufbringen einer weiteren Vergussmasse unter hohem Einspritzdruck. Weiterhin wird eine geringere Dicke der Abdeckung möglich. Dies führt unter anderem zu einer Kostenersparnis. Weiterhin kann eine große Dicke der Abdeckung zu einer unerwünschten Wölbung des Wafers führen.

Bei einer beispielhaften Abdeckung können die Erhebungen und/oder Vertiefungen sowohl an einer Oberseite als auch an einer Unterseite einer Schicht der Abdeckung ausgebildet sein. Dabei ist die Dicke der Schicht beispielsweise über die gesamte Fläche der Schicht konstant. Die Unterseite und Oberseite einer Schicht sind entsprechend wie die Unterseite und Oberseite der gesamten Abdeckung in Bezug auf die Orientierung zur Bauelementstruktur bzw. zum Trägersubstrat definiert.

Bei einer beispielhaften Abdeckung können die Erhebungen und/oder Vertiefungen nur an einer Oberseite oder nur an einer Unterseite der Schicht ausgebildet sein. Die Dicke der Schicht unterscheidet sich beispielsweise am Ort der Erhebungen von der Dicke der Schicht an anderen Orten. Beispielsweise ist die Schicht am Ort einer Erhebung dicker als an anderen Orten. Am Ort einer Vertiefung ist die Schicht beispielsweise dünner als an anderen Orten.

Bei einer beispielhaften Abdeckung weisen die Erhebungen und/oder Vertiefungen eine längliche Form auf. Insbesondere sind die Erhebungen und/oder Vertiefungen bei einer Aufsicht auf die Abdeckung in einer Richtung deutlich länger ausgebildet als in einer Richtung senkrecht dazu. Vorzugsweise verlaufen die Erhebungen und/oder Vertiefungen entlang einer gemeinsamen Richtung. Beispielsweise sind die Erhebungen in einer Richtung senkrecht zur Längsrichtung in regelmäßigen Abständen angeordnet. Bei einer beispielhaften Abdeckung weist die Schicht eine Wellenform auf. Die Erhebungen können insbesondere zu einer gewellten oder geriffelten Oberflächenstruktur der Schicht führen.

Bei einer beispielhaften Abdeckung weist die Schicht im Querschnitt eine sinusförmige Außenkontur auf. In weiteren Beispielen verläuft die Außenkontur trapezförmig oder dreieckig. Die Erhebungen sind beispielsweise zackenförmig oder zackenförmig mit einer gekappten Spitze ausgebildet.

Die Strukturierung kann auch weder als Riffelung noch in Wellenform ausgebildet sein. Beispielsweise ist die Strukturierung ähnlich wie bei einem Eierkarton ausgebildet.

Gemäß der Erfindung weist die Abdeckung mehrere übereinander angeordnete Schichten auf. Die Strukturierung ist dabei in wenigstens einer der Schichten ausgebildet. Beispielsweise weist die Abdeckung eine unterste Schicht und eine oberste Schicht auf. Die Unterseite der untersten Schicht bildet dabei die Unterseite der Abdeckung. Die Oberseite der obersten Schicht bildet die Oberseite der Abdeckung.

Gemäß der Erfindung weist die Abdeckung eine unterste Schicht, wenigstens eine mittlere Schicht und eine oberste Schicht auf. Somit ist die Abdeckung wenigstens dreischichtig ausgebildet. Es können auch mehrere mittlere Schichten zwischen der obersten und untersten Schicht angeordnet sein. Die mittlere Schicht bildet beispielsweise eine Stützschicht. Beispielsweise weist das Material der mittleren Schicht im Vergleich zur obersten und untersten Schicht eine relativ geringe Eigensteifigkeit auf. Beispielsweise weist die unterste Schicht ein Siliziumoxid, die mittlere Schicht ein Polymer und die oberste Schicht ein Siliziumnitrid auf.

In einer beispielhaften Abdeckung ist die Strukturierung wenigstens an der Unterseite der Abdeckung ausgebildet. Beispielsweise wird eine derartige Strukturierung durch eine entsprechende Strukturierung eines Opfermaterials erzeugt. Dabei wird auf einem Trägersubstrat ein Opfermaterial, insbesondere eine Opferschicht aufgebracht. Das Opfermaterial bedeckt beispielsweise eine Bauelementstruktur. Das Opfermaterial wird beispielsweise mittels eines lithographischen Verfahrens auf das Trägersubstrat aufgebracht. Dabei kann auch eine Strukturierung des Opfermaterials erzeugt werden. Es können insbesondere Vertiefungen und/oder Erhebungen an der Oberseite des Opfermaterials ausgebildet sein. Anschließend wird eine Schicht, insbesondere die unterste Schicht, der Abdeckung auf das Opfermaterial aufgebracht. Aufgrund der Strukturierung des Opfermaterials erhält die Abdeckung an ihrer Unterseite eine komplementäre Strukturierung. Das Opfermaterial wird vorzugsweise nach dem Aufbringen der Schicht entfernt.

Gemäß der Erfindung ist die Unterseite der Abdeckung frei von der Strukturierung. Beispielsweise weist die Unterseite eine glatte Oberfläche auf. Die Unterseite kann jedoch auch Durchbrüche oder ähnliche Strukturierungen aufweisen, die nicht zur Erhöhung der mechanischen Stabilität ausgebildet sind. Ein Abdeckung, bei der die Unterseite keine Strukturierung aufweist, hat den Vorteil, dass die Strukturierung die Geometrie des Hohlraums nicht verändert. Somit kann eine Auswirkung auf die Funktionsweise des Bauelements vermieden werden.

In einer beispielhaften Abdeckung ist die Strukturierung an der Oberseite der Abdeckung ausgebildet. Beispielsweise wird hierzu eine mittlere und/oder oberste Schicht der Abdeckung mittels eines lithographischen Verfahrens aufgebracht, wobei auch die Strukturierung in diesem Verfahren erzeugt werden kann. Die Strukturierung einer obersten Schicht kann auch aufgrund einer Strukturierung einer darunter liegenden Schicht zustande kommen. Insbesondere kann die Strukturierung der obersten Schicht komplementär zur Strukturierung einer mittleren Schicht ausgebildet sein.

Gemäß der Erfindung ist die Oberseite der Abdeckung frei von der Strukturierung. Beispielsweise weist die Oberseite eine glatte Oberfläche auf. Dies hat beispielsweise den Vorteil, dass die Strukturierung weniger anfällig für eine Beschädigung von außen ist. Beispielsweise wird hierbei eine Strukturierung einer Schicht durch eine darüber liegende Schicht geglättet.

In einer beispielhaften Abdeckung weist die Abdeckung eine Kombination mehrerer Strukturierungen auf. Beispielsweise sind sowohl die Oberseite als auch die Unterseite der Abdeckung mit einer Strukturierung versehen. Beispielsweise weist die Abdeckung mehrere Schichten auf, die jeweils mit einer Strukturierung versehen sind.

Bei mehreren Strukturierungen können sich die Strukturierungen in ihrer Geometrie und/oder ihrer Orientierung unterscheiden. Beispielsweise weist eine Strukturierung längliche Erhebungen und/oder Vertiefungen auf, die entlang einer ersten Richtung verlaufen. Eine weitere Strukturierung weist ebenfalls längliche Erhebungen und/oder Vertiefungen auf, die jedoch entlang einer zweiten Richtung verlaufen. Die erste Richtung unterscheidet sich von der zweiten Richtung. Beispielsweise verlaufen die Richtungen senkrecht zueinander. Die Strukturierungen können an einer Oberseite und einer Unterseite einer Schicht ausgebildet sein. Alternativ oder zusätzlich dazu können die Strukturierungen in verschiedenen Schichten ausgebildet sein.

Gemäß der Erfindung ist sowohl die Oberseite als auch die Unterseite der Abdeckung frei von einer Strukturierung. In diesem Fall ist die Abdeckung beispielsweise mehrschichtig ausgebildet. Bei einem zweischichtigen Aufbau kann die Strukturierung beispielsweise nur an der Unterseite der obersten Schicht und/oder der Oberseite der untersten Schicht ausgebildet sein. Bei einem drei- oder mehrschichtigen Aufbau weist beispielsweise eine mittlere Schicht die Strukturierung aufweisen.

Beispielhafterweise wird ein Zwischenprodukt für ein Bauelement mit einer Abdeckung angegeben. Die Abdeckung ist wie oben beschrieben ausgebildet. Das Zwischenprodukt weist eine Opferschicht auf, die an die Unterseite der Abdeckung angrenzt. Die Opferschicht ist dazu vorgesehen, in einem späteren Verfahrensschritt wenigstens teilweise entfernt zu werden. Die Opferschicht weist an ihrer Oberseite wenigstens eine Strukturierung mit mehreren Erhebungen und/oder Vertiefungen auf.

Beispielsweise wird bei der Herstellung des Zwischenprodukts zuerst die Opferschicht aufweisend eine Strukturierung auf ein Trägersubstrat aufgebracht. Beispielsweise wird dazu ein lithographisches Verfahren verwendet. Anschließend wird auf die Opferschicht die Abdeckung aufgebracht. Vorzugsweise erhält die Abdeckung ihre Strukturierung aufgrund der Strukturierung der Opferschicht.

Gemäß einem weiteren beispielhaften Aspekt wird ein Bauelement mit einer Abdeckung angegeben. Die Abdeckung ist wie oben beschrieben ausgebildet. Das Bauelement weist zudem eine Bauelementstruktur auf, die von der Abdeckung bedeckt ist. Beispielsweise handelt es sich bei der Bauelementstruktur um eine Struktur eines MEMS-, SAW- und/oder BAW-Bauelementes. Beispielsweise ist die Bauelementstruktur als Teil eines Filters oder Duplexers ausgebildet. Es kann sich auch um eine Einheit, beispielsweise eine Filter- oder Duplexereinheit handeln.

Die durch die Strukturierung erhöhte mechanische Stabilität der Abdeckung ermöglicht es, größere Bauelementstrukturen abzudecken. Aufgrund der ermöglichten größeren Grundfläche der Abdeckung müssen nun weniger Einzelteile einer Einheit mit einer separaten Abdeckung versehen werden. Dies führt zu einer Platzersparnis und ermöglicht somit eine weitere Miniaturisierung des Bauelements. Darüber hinaus eine geringere Komplexität des Bauelements ermöglicht.

Außerdem wird ein Verfahren zur Herstellung einer beispielhaften Abdeckung für ein Bauelement angegeben. Hierbei wird ein Trägersubstrat bereitgestellt. Beispielsweise handelt es sich um ein Trägersubstrat auf Wafer-Level, das später zu mehreren Bauelementen vereinzelt wird. Auf dem Trägersubstrat können ein oder mehrere Bauelementstrukturen angeordnet sein. Es wird wenigstens eine Schicht auf das Trägersubstrat aufgebracht. Anschließend wird in die Schicht eine Strukturierung eingebracht. Die Strukturierung weist mehrere Erhebungen und/oder Vertiefungen auf. Auf die strukturierte Schicht können ein oder mehrere weitere Schichten aufgebracht werden.

Beispielhafterweise handelt es sich bei der strukturierten Schicht um eine Opferschicht, die in einem späteren Verfahrensschritt ganz oder teilweise entfernt wird. Beispielsweise wird auf die strukturierte Opferschicht eine Schicht der Abdeckung aufgebracht. Die Schicht der Abdeckung erhält ihre Strukturierung durch die Strukturierung der Opferschicht.

Beispielhafterweise wird eine Opferschicht aufgebracht, die keine Strukturierung an der Oberseite aufweist. Auf die Opferschicht wird eine unterste Schicht der Abdeckung aufgebracht. Diese Schicht weist beispielsweise eine Strukturierung, insbesondere an der Oberseite, auf.

Beispielhafterweise wird auf die unterste Schicht der Abdeckung eine weitere Schicht der Abdeckung aufgebracht. Die weitere Schicht kann derart ausgebildet sein, dass die Oberseite der weiteren Schicht frei von der Strukturierung ist. Beispielsweise ist die weitere Schicht derart ausgebildet, dass Vertiefungen in der untersten Schicht aufgefüllt sind. In einem Beispiel kann eine zusätzliche Glättung der Oberseite der weiteren Schicht erfolgen.

In der vorliegenden Offenbarung sind mehrere Aspekte einer Erfindung beschrieben. Alle Eigenschaften, die in Bezug auf die Abdeckung, das Zwischenprodukt, das Bauelement und das Verfahren offenbart sind, sind auch entsprechend in Bezug auf die jeweiligen anderen Aspekte offenbart und umgekehrt, auch wenn die jeweilige Eigenschaft nicht explizit im Kontext des jeweiligen Aspekts erwähnt wird.

Im Folgenden werden die hier beschriebenen Gegenstände anhand von schematischen und nicht maßstabsgetreuen Ausführungsbeispielen näher erläutert.

### Es zeigen:

- Figur 1A: im schematischen Querschnitt ein erstes Beispiel einer Abdeckung,
- Figur 1B: in der Aufsicht die Abdeckung aus Figur 1A,
- Figuren 2 und 3: in schematischen Querschnitten erfindungsgemäße Ausführungsformen einer Abdeckung.
- Figuren 4 und 5: in schematischen Querschnitten weitere Beispiele einer Abdeckung.

Vorzugsweise verweisen in den folgenden Figuren gleiche Bezugszeichen auf funktionell oder strukturell entsprechende Teile der verschiedenen Beispiele und Ausführungsformen.

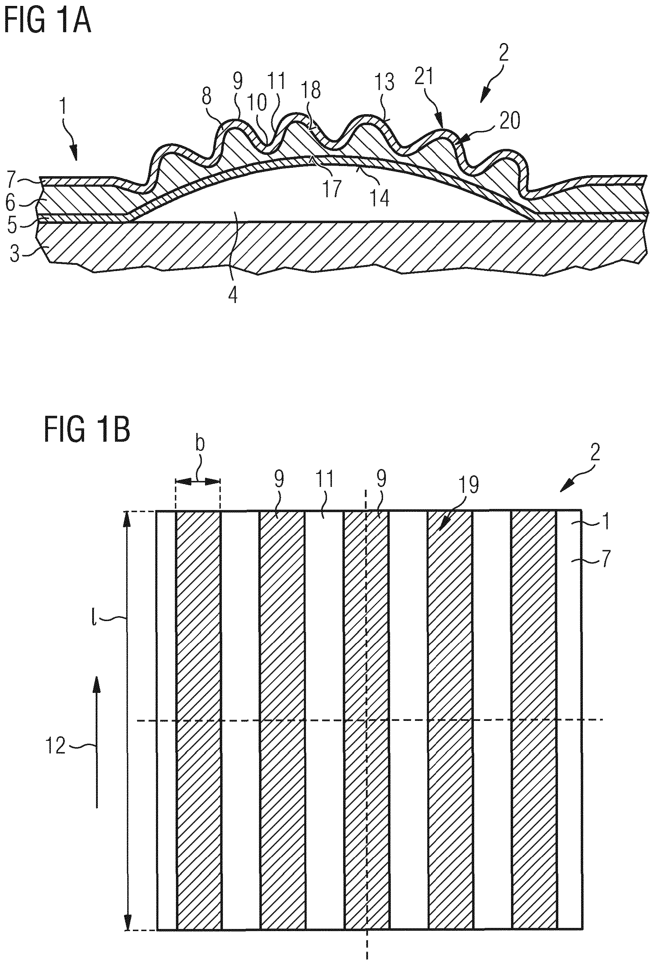

Figur 1A zeigt eine Abdeckung 1 für ein Bauelement 2 in einem Querschnitt. Figur 1B zeigt die Abdeckung 1 in einer Aufsicht. Das Bauelement 2 ist beispielsweise als MEMS-, BAW- oder SAW-Bauelement ausgebildet.

Die Abdeckung 1 ist auf einem Trägersubstrat 3 aufgebracht und schließt mit dem Trägersubstrat 3 einen Hohlraum 4 ein. Im Hohlraum 4 können ein oder mehrere Bauelementstrukturen (nicht abgebildet) angeordnet sein. Beispielsweise handelt es sich um Bauelementstrukturen für einen Filter und/oder Duplexer. Insbesondere können die Bauelementstrukturen ein oder mehrere Resonatoren umfassen. Die Bauelementstrukturen können jedoch auch von anderer Art sein. Die Abdeckung 1 verkapselt beispielsweise die Bauelementstruktur, insbesondere kann eine hermetische Verkapselung bestehen. Das Bauelement 2 ist mit der Abdeckung 1 beispielsweise in Package-Form bereitgestellt.

Die Abdeckung weist mehrere Schichten 5, 6, 7 auf. Eine unterste Schicht 5 grenzt direkt an den Hohlraum 4 an. Beispielsweise weist die unterste Schicht ein Siliziumoxid auf. Eine mittlere Schicht 6 weist beispielsweise ein Polymer auf. Eine oberste Schicht 7 schließt das Bauelement nach außen hin ab. Beispielsweise weist die oberste Schicht 7 ein Siliziumnitrid auf. Die unterste und die oberste Schicht 5, 7 sind beispielsweise im Vergleich zur mittleren Schicht 6 relativ hart. Die mittlere Schicht 6 fungiert beispielsweise als Stützschicht.

Wenigstens eine der Schichten 5, 6, 7 der Abdeckung 1 ist mit einer Strukturierung 20, 21 versehen. Die Strukturierung 20, 21 dient zur Erhöhung der Stabilität der Abdeckung 1. Insbesondere kann durch eine Strukturierung 20 der mittleren Schicht 6 die Stabilität erhöht werden. Die unterste und/oder oberste Schicht 5, 7 weisen beispielsweise Strukturierungen komplementär zur Strukturierung 20 der mittleren Schicht 6 auf.

In der in den Figuren 1A und 1B gezeigten Beispielen weisen die mittlere Schicht 6 und die oberste Schicht 7 jeweils eine Strukturierung 20, 21 mit länglichen Erhebungen 8, 9 auf. Analog weisen die mittlere Schicht 6 und die oberste Schicht 7 Vertiefungen 10, 11 auf, die zwischen den Erhebungen 8, 9 ausgebildet sind. Die mittlere Schicht 6 weist an ihrer Oberseite 18 die Strukturierung 20 auf. Die Unterseite 17 der mittleren Schicht 6 weist keine Strukturierung auf.

Die Erhebungen 9 in der obersten Schicht 7 bilden Erhebungen an der Oberseite 13 der Abdeckung 1. Die Oberseite 13 der Abdeckung 1 entspricht der Oberseite der obersten Schicht 7.

Die Erhebungen 8, 9 sind regelmäßig angeordnet und weisen eine einheitliche Geometrie auf. Insbesondere sind die Längen 1 und die Breiten b der Erhebungen 8, 9 ähnlich oder identisch. Die Erhebungen 8, 9 verlaufen entlang einer gemeinsamen Richtung 12. Durch die Erhebungen 8, 9 erhalten die mittlere und die obere Schicht 6, 7 eine gewellte Struktur.

Die Erhebungen 8, 9 führen zu einer Erhöhung der mechanischen Stabilität der Abdeckung 1 ähnlich wie bei einem Wellblechdach eines Gebäudes oder einer Wellpappe. Dies ermöglicht es, die Dicke der Abdeckung 1 bei ausreichender Stabilität gering zu halten. Insbesondere können auch Abdeckungen 1 mit einer großen Grundfläche ausgebildet verwenden, ohne dass die Dicke der Abdeckung 1 erhöht werden muss. Dies ermöglicht es beispielsweise, eine gesamte Filter und/oder Duplexereinheit mit einer einzigen großen Abdeckung zu versehen, anstatt Einzelteile, wie z. B. ein oder mehrere Resonatoren, mit mehreren, separaten Abdeckungen zu versehen.

Beispielsweise weist die abzudeckende Bauelementstruktur und/oder Bauelementanordnung in der Aufsicht eine längliche Form auf. In diesem Fall verlaufen die Erhebungen 8, 9 beispielsweise senkrecht zur Längsrichtung der Bauelementanordnung. Die Erhebungen 8, 9 können auch nicht länglich ausgebildet sein. Beispielsweise ist die Strukturierung wie bei einem Eierkarton ausgebildet. Dies ist beispielsweise bei einer Bauelementstruktur oder Bauelementanordnung vorteilhaft, die keine lange Seite aufweist, beispielsweise quadratisch ausgebildet ist.

Die Erhebungen 8, 9 erstrecken sich beispielsweise nahezu über die gesamte Fläche der Abdeckung 1. In einem anderen Beispiel kann die Abdeckung 1 nur auf einem Teil ihrer Fläche mit den Erhebungen 8, 9 versehen sein.

Die unterste Schicht 5 ist frei von Erhebungen. Insbesondere weist die Unterseite 14 der Abdeckung, die von der dem Hohlraum 4 zugewandten Seite der untersten Schicht 5 gebildet wird, eine glatte Oberfläche auf. Insbesondere weist die Unterseite 14 keine Erhebungen oder Vertiefungen auf. Somit wirken sich die Erhebungen 8, 9 nicht auf die Form des Hohlraums 4 auf.

Die Abdeckung 1 ist vorzugsweise in Dünnschicht-Technologie hergestellt. Beispielsweise wird zur Ausbildung der Abdeckung 1 zuerst eine Opferschicht auf das Trägersubstrat 3 aufgebracht. Die Opferschicht weist in dem abgebildeten Beispiel eine glatte Oberseite auf.

Auf die Opferschicht wird die unterste Schicht 5 aufgebracht. Danach wird die Opferschicht beispielsweise ganz oder teilweise entfernt. Zur Entfernung der Opferschicht kann in der untersten Schicht 5 eine Öffnung ausgebildet sein. Auf die unterste Schicht 5 wird die mittlere Schicht 6 aufgebracht. Durch die mittlere Schicht 6 kann die Öffnung in der untersten Schicht 5 verschlossen werden. Die mittlere Schicht 6 wird beispielsweise mittels eines lithographischen Verfahrens aufgetragen und dabei strukturiert. Beispielsweise wird eine Graumaske verwendet. Die Graumaske kann dabei sehr feine Löcher aufweisen, die nicht aufgelöst werden. Je nach Ausbildung der Löcher kann die Strukturierung 20 mehr oder weniger steile Flanken aufweisen.

Auf die mittlere Schicht 6 wird schließlich die oberste Schicht 7 aufgebracht. Die oberste Schicht 7 erhält ihre Strukturierung 21 durch die Strukturierung 20 der mittleren Schicht 6, so dass eine komplementäre Strukturierung 21 gebildet wird.

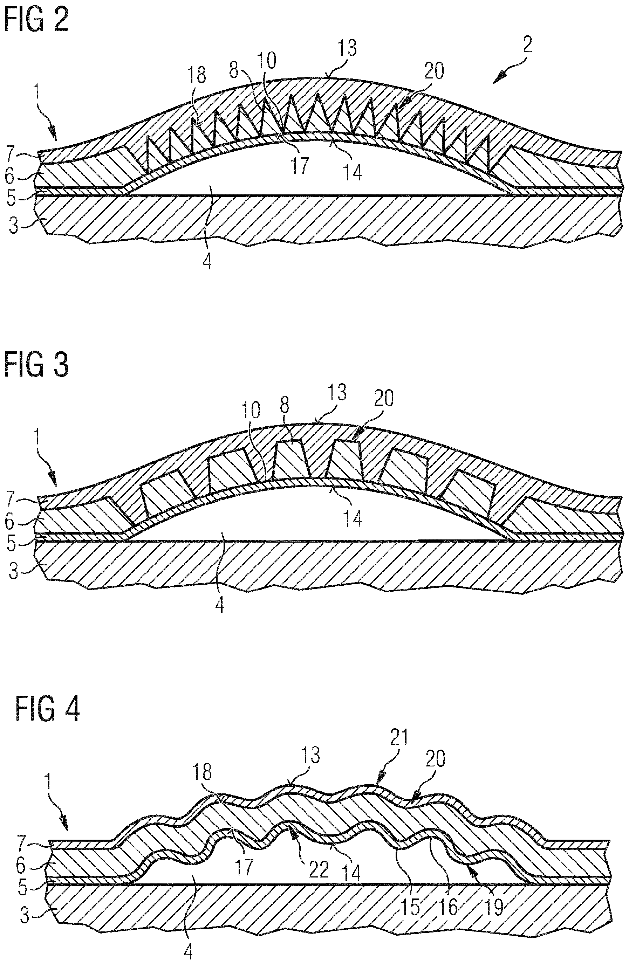

Figur 2 zeigt als Ausführungsform der Erfindung ein Abdeckung 1. Auch hier umfasst die Abdeckung 1 drei Schichten 5, 6, 7. Allerdings ist hier im Gegensatz zur beispielhaften Abdeckung aus Figur 1A die Strukturierung 20 nicht von außen sichtbar.

Die mittlere Schicht 6 weist auf ihrer Oberseite 18 eine Strukturierung 20 mit Erhebungen 8 bzw. Vertiefungen 10 auf. Die Strukturierung 20 ist zackenförmig ausgebildet. Die Unterseite der obersten Schicht 6 ist komplementär zur Oberseite 18 ausgebildet, d.h., weist ebenfalls eine zackenförmige Strukturierung auf.

Die Oberseite 13 der Abdeckung 1, die durch die Oberseite der obersten Schicht 7 gebildet wird, ist glatt ausgebildet. Insbesondere sind an der Oberseite 13 keine Erhebungen oder Vertiefungen vorhanden. Beispielsweise wird die oberste Schicht 7 derart aufgebracht, dass die Vertiefungen in der mittleren Schicht 6 vollständig mit dem Material der obersten Schicht 7 aufgefüllt werden. Die oberste Schicht 7 kann zusätzlich noch von außen geglättet sein.

Beispielsweise kann eine wellenförmige Strukturierung in einer oder in mehreren Schichten 5, 6, 7 der Abdeckung 1 gemäß Figur 1A vorhanden sein, wobei die Oberseite 13 der Abdeckung 1 wie in Figur 2 glatt ausgebildet ist. Andererseits kann auch eine zackenförmige Strukturierung 20 gemäß Figur 2 vorliegen und eine komplementäre Strukturierung 21 an der Oberseite 13 ausgebildet sein. Die Strukturierung 20 kann auch in der mittleren Schicht 6 zackenförmig ausgebildet sein und an der Oberseite 13 in eine wellenförmige Strukturierung 21 übergehen.

Figur 3 zeigt als weitere Ausführungsform der Erfindung eine Abdeckung 1. Auch hier ist die Oberseite 13 und Unterseite 14 der Abdeckung 1 glatt ausgebildet. Die Ausführungsform unterscheidet sich von der Ausführungsform aus Figur 2 in der Form der Strukturierung der mittleren Schicht 6.

Die mittlere Schicht 6 weist längliche Erhebungen 8 mit einem trapezförmigen Querschnitt auf. Die Basis des Trapezes ist länger als die ihr gegenüberliegende Seite. Die Basis kann auch kürzer sein als oder gleich lang sein wie die gegenüberliegende Seite.

Zwischen den Erhebungen 8 sind Vertiefungen 10 ausgebildet. Die Vertiefungen 10 bilden Aussparungen in der mittleren Schicht 6 und reichen bis zur untersten Schicht 5. Somit sind die Erhebungen 9 der mittleren Schicht 6 nicht miteinander verbunden. Die Vertiefungen 10 sind vom Material der obersten Schicht 7 vollständig aufgefüllt.

Figur 4 zeigt ein weiteres Beispiel einer Abdeckung 1. Im Unterschied zu den in den Figuren 1A bis 3 gezeigten Abdeckungen weist die Unterseite 14 der Abdeckung eine Strukturierung 19 auf. Insbesondere sind an der Unterseite 14 Erhebungen 15 und Vertiefungen 16 vorhanden. Die Strukturierung 19 ist wellenförmig ausgebildet. Es kann aber auch eine andere Form der Strukturierung vorhanden sein.

Die Strukturierung 19 an der Unterseite 14 wird beispielsweise durch eine an der Oberseite strukturierte Opferschicht erzeugt. Die unterste Schicht 5 erhält somit eine komplementäre Strukturierung 19. Die mittlere Schicht erhält ebenfalls komplementäre Strukturierungen 22, 20 an ihrer Unterseite 17 und ihrer Oberseite 18. Die Oberseite 13 der Abdeckung 1 ist ebenfalls in komplementärer Weise, insbesondere wellenförmig, strukturiert.

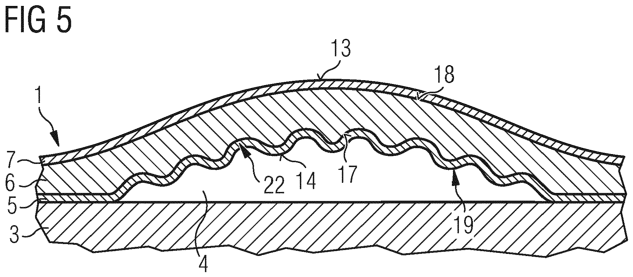

Figur 5 zeigt ein weiteres Beispiel einer Abdeckung 1, bei der eine Strukturierung 19 an der Unterseite 14 der Abdeckung 1 vorhanden ist. Im Unterschied zur Figur 4 ist die Oberseite 13 der Abdeckung 1 glatt ausgebildet.

Die mittlere Schicht 6 weist nur an ihrer Unterseite 17 eine Strukturierung 22 auf. Die Oberseite 18 der mittleren Schicht 6 ist glatt ausgebildet. Die Geometrie der obersten Schicht 7 ist komplementär zur Geometrie der Oberseite 18 der mittleren Schicht 6. Insbesondere weist die oberste Schicht 7 keine Strukturierung auf und ist somit an ihrer Oberseite und der Unterseite glatt ausgebildet. Die Geometrie der Oberseite 13 der Abdeckung ist somit komplementär zur Geometrie der Oberseite 18 der mittleren Schicht 6.

Beispielsweisekann die Oberseite 18 der mittleren Schicht 6 analog zu den Abdeckungen der Figuren 2 und 3 ebenfalls eine Strukturierung aufweisen. Die oberste Schicht 7 kann die Vertiefungen vollständig auffüllen und eine glatte Oberseite aufweisen, so dass die Oberseite 13 der Abdeckung 1 glatt ausgebildet ist.

Beispielsweisekönnen verschiedene Schichten 5, 6, 7 der Abdeckung unterschiedliche Strukturierungen aufweisen. Beispielsweise weist die unterste 5 Schicht an ihrer Unterseite 14 eine Strukturierung 19 auf, bei der längliche Erhebungen in einer ersten Richtung verlaufen. Die oberste Schicht 7 weist beispielsweise an ihrer Oberseite 13 eine Strukturierung 21 auf, bei der längliche Erhebungen in einer zweiten Richtung verlaufen, die nicht mit der ersten Richtung übereinstimmt. Beispielsweise verläuft die zweite Richtung senkrecht zur ersten Richtung.

## Patentansprüche

1. Abdeckung für ein mikro-elektromechanisches Bauelement, wobei die Abdeckung (1) wenigstens eine Schicht (5, 6, 7) umfasst, die eine Strukturierung (19, 20, 21, 22) mit mehreren Erhebungen (8, 9, 15) und Vertiefungen (10, 11, 16) aufweist,
wobei die Strukturierung der Erhöhung der mechanischen Stabilität der Abdeckung dient;
wobei die Abdeckung mehrere übereinander angeordnete Schichten (5, 6, 7) aufweist,
wobei die Abdeckung eine unterste Schicht (5), wenigstens eine mittlere Schicht (6) und eine oberste Schicht (7) aufweist,
wobei eine Unterseite (14) der untersten Schicht (5) die Unterseite der Abdeckung (1) bildet und eine Oberseite (13) der obersten Schicht (7) die Oberseite der Abdeckung (1) bildet;
wobei die Unterseite (14) und die Oberseite (13) der Abdeckung (1) frei von Erhebungen oder Vertiefungen sind;
wobei die Strukturierung in einer der mittleren Schichten (6) und in der obersten Schicht (7) ausgebildet ist; und
wobei die eine der mittleren Schichten (6) auf ihrer Oberseite ihre Strukturierung mit Erhebungen und Vertiefungen aufweist; und
wobei die oberste Schicht (7) auf ihrer Unterseite ihre Strukturierung mit Erhebungen und Vertiefungen aufweist,
wobei die oberste Schicht (7) auf ihrer Unterseite komplementär zur Oberseite der einen der mittleren Schichten (6) ausgebildet ist, indem die Vertiefungen in der einen der mittleren Schichten (6) vollständig mit dem Material der obersten Schicht (7) aufgefüllt sind.

2. Abdeckung nach Anspruch 1,
bei der die Strukturierung (19, 20, 21, 22) als Riffelung und/oder in Wellenform ausgebildet ist.

3. Abdeckung nach einem der vorhergehenden Ansprüche,
bei der die Erhebungen (8, 9, 15) und/oder Vertiefungen (10, 11, 16) eine längliche Form aufweisen.

4. Abdeckung nach einem der vorhergehenden Ansprüche,
die einen Hohlraum (4) begrenzt.

5. Abdeckung nach einem der vorhergehenden Ansprüche,
die mehrere Strukturierungen (19, 20, 21, 22) aufweist, die sich in ihrer Geometrie und/oder ihrer Orientierung unterscheiden.

6. Bauelement mit einer Abdeckung nach einem der Ansprüche 1 bis 5 und einer Bauelementstruktur, die von der Abdeckung (1) bedeckt ist.

7. Verfahren zur Herstellung einer Abdeckung nach einem der Ansprüche 1 bis 5, umfassend die Schritte:
- Bereitstellen eines Trägersubstrats (3),
- Aufbringen wenigstens dreier übereinander angeordneter Schichten (5, 6, 7) auf das Trägersubstrat (3), wobei eine mittlere Schicht (6) und eine oberste Schicht (7) eine Strukturierung mit mehreren Erhebungen (8, 9, 15) und Vertiefungen (10, 11, 16) aufweisen, wobei die Strukturierung der Erhöhung der mechanischen Stabilität der Abdeckung dient;
wobei die eine mittlere Schicht (6) so aufgebracht wird, dass sie auf ihrer Oberseite ihre Strukturierung mit Erhebungen und Vertiefungen aufweist, und
wobei die oberste Schicht (7) so aufgebracht wird, dass sie auf ihrer Unterseite ihre Strukturierung mit Erhebungen und Vertiefungen aufweist, und
wobei die oberste Schicht (7) derart aufgebracht wird, dass sie die Vertiefungen der Struktur in der einen mittleren Schicht vollständig ausfüllt und dadurch eine komplementäre Strukturierung zu der Strukturierung der einen mittleren Schicht (6) ausbildet, und
wobei die Unterseite (14) der untersten Schicht (5) der übereinander angeordneten Schichten die Unterseite der Abdeckung (1) bildet und die Oberseite (13) der obersten Schicht (7) die Oberseite der Abdeckung (1) bildet;
wobei die Unterseite (14) und die Oberseite (13) der Abdeckung (1) frei von Erhebungen und Vertiefungen sind.

## Claims

1. A cover for a micro-electromechanical component, wherein the cover (1) comprises at least one layer (5,6,7) having a structuring (19, 20, 21, 22) with multiple elevations (8, 9, 15) and recesses (10, 11, 16),
wherein the structuring serves the increasing of the mechanical stability of the cover;
wherein the cover comprises multiple stacked layers (5,6,7),
wherein the cover comprises a bottommost layer (5), one or more middle layers (6) and a topmost layer (7),
wherein a bottom side (14) of the bottommost layer (5) forms the bottom side of the cover (1) and a top side (13) of the topmost layer (7) forms the top side of the cover (1);
wherein the bottom side (14) and the top side (13) of the cover (1) being free from elevations or recesses;
wherein the structuring is formed in one of the middle layers (6) and in the topmost layer (7); and
wherein the one of the middle layers (6) having on its top side its structuring with elevations and recesses; and
wherein the topmost layer (7) having on its bottom side its structuring with elevations and recesses,
wherein the topmost layer (7) is formed on its bottom side complementary to the top side of the one of the middle layers (6) by completely filling the recesses in the one of the middle layers (6) with the material of the topmost layer (7).

2. The cover of claim 1, in which the structuring (19, 20, 21, 22) is in the form of ripples and / or waves.

3. The cover according to one of the preceding claims, in which the elevations (8,9,15) and / or the recesses (10, 11, 16) have an elongated shape.

4. The cover according to one of the preceding claims, limiting a cavity (4).

5. The cover according to one of the preceding claims, that has multiple structurings (19, 20, 21, 22) that differ in their geometry and / or orientation.

6. A component with a cover according to any one of claims 1 to 5 and a component structure covered by the cover (1).

7. A method of manufacturing a cover according to one of claims 1 to 5, comprising the steps:
- providing a carrier substrate (3)
- applying at least three stacked layers (5,6,7) on the carrier substrate (3), wherein a middle layer (6) and a topmost layer (7) having a structuring with multiple elevations (8, 9, 15) and recesses (10, 11, 16), wherein the structuring serves the increasing of the mechanical stability of the cover;
wherein the middle layer (6) being applied in such a way that it has on its top side its structuring with elevations and recesses, and
wherein the topmost layer (7) being applied in such a way that it has on its bottom side its structuring with elevations and recesses, and
wherein the topmost layer (7) being applied in such a way that it completely fills the recesses of the structure of the middle layer and therefore forms a structuring complementary to the structuring of the middle layer (6), and
wherein the bottom side (14) of the bottommost layer (5) of the stacked layers forming the bottom side of the cover (1) and the top side (13) of the topmost layer (7) forming the top side of the cover (1);
wherein the bottom side (14) and the top side (13) of the cover (1) being free from elevations and recesses.

## Revendications

1. Capot pour composant microélectromécanique, dans lequel le capot (1) comprend au moins une couche (5, 6, 7) qui présente une structuration (19, 20, 21, 22) avec plusieurs reliefs (8, 9, 15) et renfoncements (10, 11, 16),
dans lequel la structuration des reliefs assure la stabilité mécanique du capot ;
dans lequel le capot présente plusieurs couches (5, 6, 7) disposées les unes au-dessus des autres,
dans lequel le capot présente une couche inférieure (5), au moins une couche centrale (6) et une couche supérieure (7),
dans lequel une face inférieure (14) de la couche inférieure (5) forme la face inférieure du capot (1) et une face supérieure (13) de la couche supérieure (7) forme la face supérieure du capot (1);
dans lequel la face inférieure (14) et la face supérieure (13) du capot (1) sont sans reliefs ou renfoncements;
dans lequel la structuration est réalisée dans l'une des couches centrales (6) et dans la couche supérieure (7); et
dans lequel l'une couche centrale (6) présente sur sa face supérieure sa structuration avec des reliefs et des renfoncements; et
dans lequel la couche supérieure (7) présente sur sa face inférieure sa structuration avec des reliefs et des renfoncements,
dans lequel la couche supérieure (7) est réalisée sur sa face inférieure de manière complémentaire par rapport à la face supérieure de l'une couche centrale (6) en ce que les renfoncements de l'une couche centrale (6) sont remplis en totalité du matériau de la couche supérieure (7).

2. Capot selon la revendication 1,
où la structuration (19, 20, 21, 22) est réalisée en tant que striure et/ou sous forme ondulée.

3. Capot selon l'une des revendications précédentes,
où les reliefs (8, 9, 15) et/ou les renfoncements (10, 11, 16) présentent une forme allongée.

4. Capot selon l'une des revendications précédentes,
qui délimite une cavité (4).

5. Capot selon l'une des revendications précédentes,
qui présente plusieurs structurations (19, 20, 21, 22), qui se distinguent par leur géométrie et/ou leur orientation.

6. Composant avec un capot selon l'une des revendications 1 à 5 et une structure de composant qui est recouverte par le capot (1).

7. Procédé servant à la fabrication d'un capot selon l'une des revendications 1 à 5, comprenant les étapes de:
- obtention d'un substrat de support (3),
- application sur le substrat de support (3) d'au moins trois couches (5, 6, 7) disposées les unes au-dessus des autres, où une couche centrale (6) et une couche supérieure (7) présentent une structuration avec plusieurs reliefs (8, 9, 15) et renfoncements (10, 11, 16), la structuration des reliefs assurant la stabilité mécanique du capot ;
dans lequel la couche centrale (6) est appliquée de telle sorte qu'elle présente sur sa face supérieure sa structuration avec des reliefs et des renfoncements, et
dans lequel la couche supérieure (7) est appliquée de telle sorte qu'elle présente sur sa face inférieure sa structuration avec des reliefs et des renfoncements, et
dans lequel la couche supérieure (7) est appliquée de telle manière qu'elle remplisse en totalité les renfoncements de la structure de la couche centrale et réalise ainsi une structuration complémentaire par rapport à la structuration de la couche centrale (6), et dans lequel la face inférieure (14) de la couche inférieure (5) des couches disposées les unes au-dessus des autres forme la face inférieure du capot (1) et la face supérieure (13) de la couche supérieure (7) forme la face supérieure du capot (1) ;
dans lequel la face inférieure (14) et la face supérieure (13) du capot (1) sont sans reliefs et renfoncements.
